(19) **Europäisches Patentamt / European Patent Office / Office européen des brevets**

(11) **EP 4 174 508 B1**

(12) **EUROPEAN PATENT SPECIFICATION**

(45) Date of publication and mention
of the grant of the patent:
**29.04.2026 Bulletin 2026/18**

(21) Application number: **21834659.1**

(22) Date of filing: **28.06.2021**

(51) International Patent Classification (IPC):
**G01R 31/52** *(2020.01)* **G01R 27/20** *(2006.01)*
**G01R 31/54** *(2020.01)*

(52) Cooperative Patent Classification (CPC):
**G01R 31/54; G01R 27/20; G01R 31/52**

(86) International application number:
**PCT/CN2021/102772**

(87) International publication number:
**WO 2022/001962 (06.01.2022 Gazette 2022/01)**

(54) **CONNECTION DETECTION CIRCUIT, ALARM DEVICE, AND BASE STATION**

VERBINDUNGSDETEKTIONSSCHALTUNG, ALARMVORRICHTUNG UND BASISSTATION

CIRCUIT DE DÉTECTION DE CONNEXION, DISPOSITIF D'ALARME ET STATION DE BASE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.06.2020 CN 202010599533**

(43) Date of publication of application:
**03.05.2023 Bulletin 2023/18**

(73) Proprietor: **ZTE Corporation
Shenzhen, Guangdong 518057 (CN)**

(72) Inventors:
• **WANG, Aoyun
Shenzhen, Guangdong 518057 (CN)**
• **WANG, Deju
Shenzhen, Guangdong 518057 (CN)**
• **MA, Jinbo
Shenzhen, Guangdong 518057 (CN)**
• **XIAO, Kaixiang
Shenzhen, Guangdong 518057 (CN)**
• **WANG, Guohui
Shenzhen, Guangdong 518057 (CN)**
• **LI, Huijuan
Shenzhen, Guangdong 518057 (CN)**

(74) Representative: **Zoli, Filippo
Brunacci & Partners S.r.l.
Via Pietro Giardini, 625
41125 Modena (IT)**

(56) References cited:
| | |
|---|---|
| WO-A1-2017/108134 | CN-A- 108 027 399 |
| CN-A- 110 297 156 | CN-A- 112 394 295 |
| CN-U- 202 268 943 | CN-U- 202 433 470 |
| CN-U- 203 561 719 | CN-U- 203 561 719 |
| CN-U- 206 583 996 | US-A1- 2014 015 538 |
| US-A1- 2016 306 003 | US-A1- 2018 149 688 |

# Description

## TECHNICAL FIELD

The present invention relates to the field of electronic technologies, and in particular to a connection detection circuit, an alarm apparatus, and a base station.

## BACKGROUND

Communication base stations play a vital role in communication networks. Base stations are often installed at high places, and are therefore often prone to the risk of lightning damage. The grounding status of a base station system (including communication equipment, equipment chassis, and the like) is an important part of a lightning protection system, and if the base station system has a poor grounding, the life safety of maintenance personnel is very likely in danger.

A grounding detection device of a current base station system only detects whether protective earthing (PE) of a system casing is connected or disconnected. The detection accuracy is low. As a result, in some cases of poor grounding, although an actual impedance on a grounding line is relatively large, the impedance is still in an impedance range for the detection device to report that grounding is normal, which causes safety potential risks to the use of a base station.

US2018/0149688A1 discloses a grounding detection apparatus, a control method thereof and a pool system. The grounding detection apparatus includes a detection circuit, which includes a live line connection terminal, a neutral line connection terminal, a grounding terminal, a first impedance circuit, a sampling resistance, a differential amplifying circuit and a comparison unit; a first terminal of the first impedance circuit is connected with the live line connection terminal; a second terminal of the first impedance circuit is connected with a first terminal of the sampling resistance and a first input terminal of the differential amplifying circuit; the sampling resistance is configured to convert a sampling current to a sampling voltage; the differential amplifying circuit is configured to amplify the sampling voltage to form an amplified sampling voltage; and the comparison unit is configured to compare a threshold voltage and the amplified sampling voltage and output a comparison result.

CN203561719U relates to a ground wire connection state detecting and alarming device, and a power source. The device can be mounted inside the power source. The power source has an access end used for inputting electric energy and equipped with a ground wire. The ground wire connection state detecting and alarming device includes a ground wire connection state detecting circuit connected with the ground wire and used for detecting whether the ground wire is connected with the ground; and an alarming apparatus connected with the ground wire connection state detecting circuit and used for alarming if the ground wire is not connected with the ground.

WO2017/108134A1 discloses a circuit for detecting electrical shock hazard on a metal enclosure of an alternating current equipment. The circuit include a voltage sample and rectifying module and a voltage comparison module, where the voltage sample and rectifying module is connected between a line conductor and the metal enclosure, and is configured to sample a line-to-enclosure sample voltage and rectify the line-to-enclosure sample voltage (VR, LE); and output the rectified line-to-enclosure sample voltage (VR, LE) to the voltage comparison module. The voltage comparison module is configured to compare the rectified line-to-enclosure sample voltage (VR, LE) with a first threshold voltage, and to detect an electrical shock hazard on the metal enclosure when the rectified line-to-enclosure sample voltage (VR, LE) is lower than the first threshold voltage.

## SUMMARY

The invention is set out in the appended set of claims.

The following is an overview of the subject matter described in detail herein. This overview is not intended to limit the scope of protection of the claims.

Embodiments of the present invention provide a connection detection circuit, an alarm apparatus, and a base station.

In accordance with an aspect of the present invention, an embodiment provides a connection detection circuit, including: a first connection port, configured to be connected to a first voltage reference plane; a detection module, including a first detection member, a second detection member, and a detection output terminal, where the first detection member is serially connected between the first connection port and the detection output terminal, and the second detection member is serially connected between the detection output terminal and a second voltage reference plane; a signal processing module, including a signal input terminal and a signal output terminal, where the signal input terminal is connected to the detection output terminal, and the signal processing module is configured to generate, according to a first detection signal outputted by the detection module through the detection output terminal, a second detection signal that changes with the first detection signal; and an alarm module, connected to the signal output terminal, and configured to determine a connected state between the second voltage reference plane and the first voltage reference plane according to the second detection signal outputted by the signal output terminal.

In accordance with another aspect of the present invention, an embodiment provides an alarm apparatus, including the foregoing connection detection circuit.

In accordance with another aspect of the present invention, an embodiment provides a base station, including the foregoing alarm apparatus.

Other features and advantages of the present invention will be set forth in the subsequent specification and, in part, will become apparent from the specification or will be understood by carrying out the present invention. The objects and other advantages of the present invention may be realized and obtained by means of the construction specifically indicated in the specification, the claims, and the accompanying drawings.

**BRIEF DESCRIPTION OF DRAWINGS**

The accompanying drawings are used to provide a understanding of the technical schemes of the present invention, form part of the specification, are used together with the embodiments of the present invention to explain the technical schemes of the present invention, and do not constitute a limitation to the technical schemes of the present invention.

FIG. 1 is an overall schematic diagram of a connection detection circuit according to an embodiment of the present invention;

FIG. 2 is a specific schematic diagram of a connection detection circuit according to another embodiment of the present invention; and

FIG. 3 is a specific schematic diagram of a connection detection circuit according to another embodiment of the present invention.

**DETAILED DESCRIPTION**

To make the objectives, technical schemes, and advantages of the present invention more comprehensible, the present invention is described below in detail with reference to the accompanying drawings and embodiments. It should be understood that the embodiments described herein are merely used to describe the present invention rather than limiting the present invention.

It should be noted that although the module division is performed in the schematic diagram of the circuit structure, in some cases it is possible to divide the modules in a different way than that in the schematic diagram of the circuit structure. The terms such as "first" and "second" in the specification and claims are only used to distinguish between similar objects, but are not used to describe a specific order or time sequence.

The present invention provides a connection detection circuit, an alarm apparatus, and a base station. The connection detection circuit includes a first connection port, a detection module, a signal processing module, and an alarm module that are sequentially connected. The first connection port is connected to a first voltage reference plane. The detection module includes a first detection member, a second detection member, and a detection output terminal. The first detection member is serially connected between the first connection port and the detection output terminal. The second detection member is serially connected between the detection output terminal and a second voltage reference plane. The detection output terminal can output a first detection signal correlated with a potential difference between the first voltage reference plane and the second voltage reference plane. The signal processing module can generate a second detection signal that changes with the first detection signal. Therefore, the alarm module can accurately determine a connected state between the second voltage reference plane and the first voltage reference plane according to the second detection signal, so that the detection accuracy and reliability of connection detection can be improved.

The embodiments of the present invention are described below with reference to the accompanying drawings.

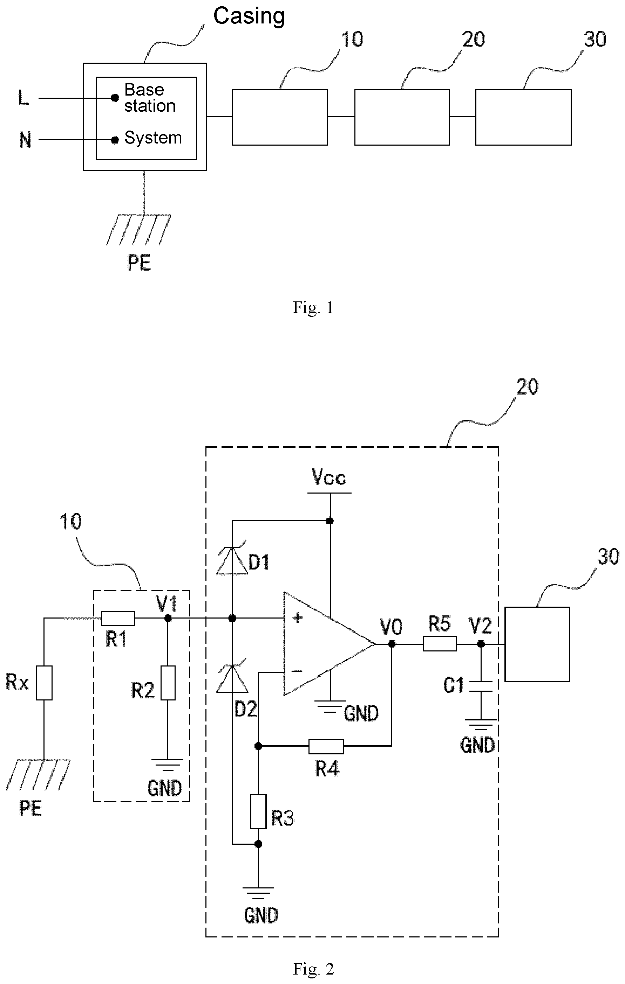

As shown in FIG. 1, an embodiment of the present invention provides a connection detection circuit, including:

- a first connection port, configured to be connected to a first voltage reference plane;

- a detection module 10, including a first detection member, a second detection member, and a detection output terminal, where the first detection member is serially connected between the first connection port and the detection output terminal, and the second detection member is serially connected between the detection output terminal and a second voltage reference plane;

- a signal processing module 20, including a signal input terminal and a signal output terminal, where the signal input terminal is connected to the detection output terminal, and the signal processing module 20 is configured to generate, according to a first detection signal outputted by the detection module 10 through the detection output terminal, a second detection signal that changes with the first detection signal;

- an alarm module 30, connected to the signal output terminal, and configured to determine a connected state between the second voltage reference plane and the first voltage reference plane according to the second detection signal outputted by the signal output terminal.

The embodiments of the present invention are described by using an example in which the connection detection circuit is configured to perform grounding detection. Various powered equipment including equipment, an alternating-current distribution cabinet, a power supply cabinet, and equipment cabinet, and the like in a communication base station all need to be connected to a copper grounding bar. Charges on a housing of the powered equipment are guided into the earth to protect workers from electric shock risks. The copper grounding bar is connected to the earth as PE and at the same time is connected to a neutral line of an alternating-current power supply at a remote end, to implement safe grounding of an entire power supply system. In an operation process of the communication base station, a connection line between a casing and the copper grounding bar inevitably wears due to external factors. To further improve electrical safety, an additional detection apparatus is usually installed on the communication base station to detect whether the powered equipment is well grounded. However, at present, the detection apparatus can only detect whether the PE is connected or disconnected. The detection accuracy is relatively low, and a false alarm may occur. Based on this, in the embodiments of the present invention, the detection module 10 is connected to the casing, so that an impedance Rx between the casing and the PE is used as a detection subject, and a grounding status is determined based on the value of the impedance Rx, thereby improving the detection accuracy and reliability. The first voltage reference plane is the casing. The casing is connected to the PE. The second voltage reference plane is functional earthing (FE, denoted as GND hereinafter). The GND is a voltage reference plane selected inside the connection detection circuit. Different voltages may be selected as references as required. The first detection member and the second detection member form a voltage divider network. In this case, the first detection signal is a first voltage value V1, and the second detection signal is a second voltage value V2. The first connection port is connected to the casing to be connected to the first voltage reference plane. That is, the first connection port is connected to the PE by the casing.

In an implementation, the detection module 10 is connected to the casing by the first connection port, so that the impedance Rx is introduced into the voltage divider network. In addition, because the GND is a reference ground of an internal circuit, in a case that the grounding is normal, there is a certain potential difference between the GND and the PE connected to the neutral line (N line) at the remote end. The potential difference is applied to a circuit between the PE and the GND, so as to obtain the first voltage value V1 corresponding to the impedance Rx on the detection output terminal.

The signal processing module 20 outputs, based on the received first voltage value V1, the second voltage value V2 that changes along with the first voltage value V1. That is, the second voltage value V2 is correlated with the impedance Rx. Obviously, the value of the impedance Rx can be calculated according to the second voltage value V2, so as to obtain the impedance amplitude of the grounding of the casing, and the safety of the grounding of the casing can be further determined. Therefore, by receiving and determining the second voltage value V2, the alarm module 30 can determine various grounding status such as whether the PE of the casing is completely disconnected and whether a poor contact occurs at present. Compared with a conventional grounding detection apparatus that can only determine whether a grounding line is connected or disconnected, in the embodiments of the present invention, the impedance between the casing and the grounding copper bar can be detected. Therefore, the detection accuracy is relatively high, and the detection is more reliable.

The impedance Rx, the first detection member, and the second detection member are connected in series to implement voltage division. The resistance values or equivalent resistance values of the first detection member and the second detection member are preset and fixed. Therefore, according to changes in the impedance Rx, the first voltage value V1 outputted by the detection output terminal between the first detection member and the second detection member is related to the impedance Rx. In an embodiment, referring to FIG. 2, when the first detection member and the second detection member are respectively a first resistor R1 and a second resistor R2, the first voltage value V1 satisfies the following formula:

$$V1 = \frac{Vpe \times R2}{R1 + R2 + Rx},$$

where Vpe is a voltage difference between the PE and the GND. As can be known from the foregoing formula, the first resistor R1 and the second resistor R2 respectively have fixed values. Therefore, the first voltage value V1 and the value of the impedance Rx have a correlation. A range of the value of the first resistor R1 can be adjusted by setting a resistance value ratio of the first resistor R1 to the second resistor R2, so that a safety range detected by the alarm module 30 can be limited. For example, in a case where positive and negative power supplies of a non-inverting amplification circuit are respectively connected to the first power supply Vcc and the GND, the first resistor R1 and the second resistor R2 may be set to limit the first voltage value V1 between a voltage value of the GND and a voltage value of the first power supply Vcc.

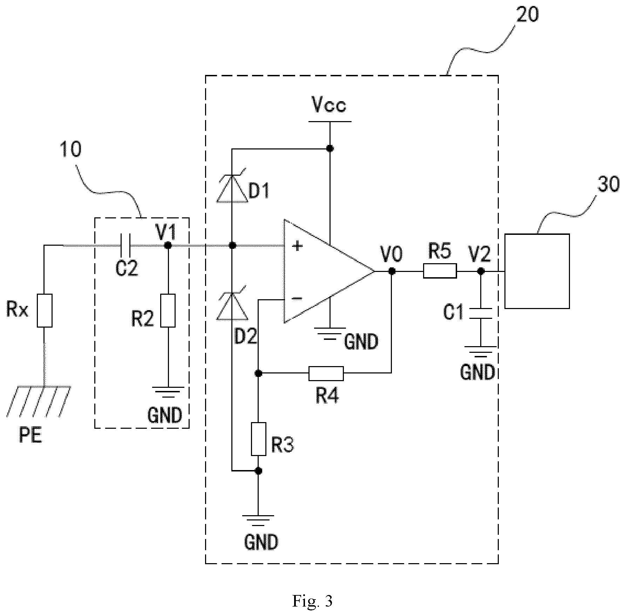

In an embodiment, referring to FIG. 3, when the first detection member and the second detection member are respectively a second capacitor C2 and the second resistor R2, the first voltage value V1 satisfies the following formula:

$$V1 = \frac{Vpe \times R2}{\frac{1}{wC2} + R2 + Rx},$$

where $w = 2\pi f$, and f is an operating frequency of an input voltage. Similarly, as can be known from the foregoing formula, the second capacitor C2 and the second resistor R2 respectively have fixed values. Therefore, the first voltage value V1 and the value of the impedance Rx have a correlation.

It can be understood that there are various implementations of voltage divider networks. The foregoing implementation of the circuit structure of the voltage divider network is only one of the implementations. Those having ordinary skill in the art can design a voltage divider network according to an actual requirement, and select appropriate components as the first detection member and the second detection member based on the rule that the first voltage value V1 corresponds to the impedance Rx to implement the foregoing functions. Various possibilities are not enumerated herein.

In an embodiment, the signal processing module 20 includes an operational amplifier, a third resistor R3, and a fourth resistor R4. The operational amplifier includes a non-inverting input terminal, an inverting input terminal, and an output terminal. The non-inverting input terminal of the operational amplifier is the signal input terminal. The inverting input terminal of the operational amplifier, the third resistor R3, and the GND are sequentially connected. The output terminal of the operational amplifier is connected to the inverting input terminal of the operational amplifier via the fourth resistor R4. Based on the output characteristics of the non-inverting amplification circuit, an amplification voltage V0 obtained after the first voltage value V1 is processed by the non-inverting amplification circuit satisfies the following formula:

$$V0 = \frac{V1 \times (R3 + R4)}{R3}.$$

Because the third resistor R3 and the fourth resistor R4 have fixed values, the amplification voltage V0 outputted by the non-inverting amplification circuit also has a correlation with the value of the impedance Rx. The amplification of the first voltage by the non-inverting amplification circuit can facilitate voltage determination by the alarm module 30, to obtain more accurate alarm control.

In an embodiment, the signal processing module 20 further includes a clamp circuit. The clamp circuit includes a second diode D2. A negative electrode of the second diode D2 is connected to the non-inverting input terminal of the operational amplifier. A positive electrode of the second diode D2 is connected to the second voltage reference plane. Through the selection of a clamp voltage of the second diode D2, a surge can be prevented from causing damage to the signal processing module 20 and back-end components. For example, in a case such as a lightening stroke, a surge may occur on a cable connecting the housing and the PE. The surge is transferred to the signal processing module 20 through the detection module 10. Through the reverse breakdown characteristic of the second diode D2, the surge may be transferred to the GND, thereby protecting the signal processing module 20.

Based on the foregoing embodiment, in an embodiment, the clamp circuit further includes a first diode D1. A negative electrode of the first diode D1 is connected to the first power supply Vcc. A positive electrode of the first diode D1 is connected to the non-inverting input terminal of the operational amplifier. Referring to FIG. 2, positive and negative electrodes of the non-inverting amplification circuit are respectively connected to the first power supply Vcc and the GND. On the same loop, the first power supply Vcc connects the second resistor R2 to the GND via the first diode D1. Therefore, based on the foregoing setting of the first voltage value V1 which is set between the voltage value of the GND and the voltage value of the first power supply Vcc, the first diode D1 also has a certain clamping effect.

In an embodiment, the signal processing module 20 further includes a filter circuit configured to perform filtering. The filter circuit is connected between the output terminal of the operational amplifier and the signal output terminal. In the embodiments of the present invention, filter processing is performed on an electrical signal by the filter circuit, to reduce interference with the alarm module 30 by noise and also facilitate the recognition and alarming of the alarm module 30.

In an embodiment, the filter circuit includes a fifth resistor R5 and a first capacitor C1. The output terminal of the operational amplifier, the fifth resistor R5, the first capacitor C1, and the second voltage reference plane are sequentially connected. The signal output terminal is connected at a connection point between the fifth resistor R5 and the first capacitor C 1, to output the second voltage value V2. The filter processing of an electrical signal can be implemented by the foregoing RC filter loop. It can be understood that the foregoing RC circuit is only one of the implementations of the filter circuit. Those having ordinary skill in the art may use a filter circuit of another structure according to the status of an electrical signal. Examples are not described one by one herein.

The alarm module 30 determines the value of the impedance Rx according to the range of the second voltage value V2. When the second voltage value V2 exceeds a preset safe voltage range, the alarm module 30 sends an alarm, for example, a voice alarm, an acousto-optic alarm, or the like.

The alarm module 30 can determine a connected state between the first connection port and the first voltage reference plane according to the value of the second detection signal, for example: when the second detection signal (that is, the second voltage value V2) is less than a first preset value, determine a nonconnected state between the first connection port and the first voltage reference plane; or, obtain an impedance between the first connection port and the first voltage reference plane according to the second detection signal (that is, the second voltage value V2), and in a case where the impedance is greater than a second preset value, determine a nonconnected state between the first connection port and the first voltage reference plane.

The first preset value and the second preset value may be set as required, and is not limited in the embodiments of the present invention.

In a case where the casing of the foregoing connection detection circuit is grounded normally, the first voltage value V1 outputted by the detection output terminal is processed by the signal processing module 20, and then the second voltage value V2 is outputted to the alarm module 30. In this case, the second voltage value V2 is within the preset safe voltage range of the alarm module 30. In this case, it is determined that the connected state between the first connection port and the first voltage reference plane is in good condition, and the value of the impedance Rx of current grounding can be obtained in real time at the alarm module 30. When the casing is grounded abnormally, for example, the impedance Rx and the first connection port are disconnected, in this case, the detection output terminal is connected to the GND by the second resistor R2, and a low-level signal is obtained on the detection output terminal. As can be learned according to the foregoing calculation process, the alarm module 30 also obtains a low-level second voltage value V2. The alarm module 30 can determine, according to the second voltage value V2, that a current grounding line is disconnected, and send an alarm. For another example, in a case where the casing is poorly grounded, the impedance Rx is equivalent to a resistor with an extremely large resistance value. In this case, the detection output terminal similarly obtains a low-level signal. That is, the second voltage value V2 is also a low-level signal. The alarm module 30 calculates, according to the second voltage value V2, that the current resistance value of the impedance Rx exceeds a safety range, and also sends an alarm.

In the embodiments of the present invention, the value of the impedance Rx of the grounding is monitored in real time to acquire the grounding status of the casing, thereby resolving conventional problems such as that a false alarm is caused due to a relatively high grounding impedance. Therefore, the reliability is high, the structure is simple, and the integration into a base station system is easy.

It can be understood that although it is only described that the connection detection circuit in the above embodiments is configured to detect a grounding status, this does not limit that the connection detection circuit can only be configured to detect a grounding status, and the connection detection circuit can also be configured to detect another connection relationship that is based on a voltage difference.

Based on the connection detection circuit in the foregoing embodiment, an example of the connection detection circuit is provided below.

Example one

As shown in FIG. 2, the connection detection circuit includes a first connection port, a detection module 10, a signal processing module 20, and an alarm module 30 that are sequentially connected. The first connection port is configured to be connected to a first voltage reference plane. The detection module 10 includes a first detection member, a second detection member, and a detection output terminal. The first detection member is serially connected between the first connection port and the detection output terminal. The second detection member is serially connected between the detection output terminal and a second voltage reference plane. The signal processing module 20 includes a signal input terminal and a signal output terminal. The signal input terminal is connected to the detection output terminal. The signal processing module 20 is configured to generate, according to a first detection signal outputted by the detection module 10 through the detection output terminal, a second detection signal that changes with the first detection signal. The alarm module 30 is connected to the signal output terminal, and is configured to determine a connected state between the second voltage reference plane and the first voltage reference plane according to the second detection signal outputted by the signal output terminal.

The first connection port is connected to the casing, so as to be connected to the PE by the casing. Rx denotes an impedance between the casing and the PE. In this way, the first voltage reference plane is the PE, and the second voltage reference plane is the GND. The first detection member is the first resistor R1, and the second detection member is the second resistor R2. The first resistor R1 and the second resistor R2 form the voltage divider network. A voltage difference Vpe between the PE and the GND is applied to a circuit formed by the impedance Rx, the first resistor R1, and the second resistor R2. In this case, the detection output terminal outputs a voltage value obtained through voltage division, which is denoted as the first voltage value V1. The first voltage value V1 satisfies the following formula:

$$V1 = \frac{Vpe \times R2}{R1 + R2 + Rx}.$$

The signal processing module 20 further includes an operational amplifier, a third resistor R3, and a fourth resistor R4. The operational amplifier includes a non-inverting input terminal, an inverting input terminal, and an output terminal. The non-inverting input terminal of the operational amplifier is the signal input terminal. The inverting input terminal of the operational amplifier, the third resistor R3, and the GND are sequentially connected. The output terminal of the operational amplifier is connected to the inverting input terminal of the operational amplifier by the fourth resistor R4. Based on the output characteristics of the non-inverting amplification circuit, an amplification voltage V0 obtained after the first voltage value V1 is processed by the non-inverting amplification circuit satisfies the following formula:

$$V0 = \frac{V1 \times (R3+R4)}{R3}.$$

The signal processing module 20 further includes a clamp circuit. The clamp circuit includes a first diode D1 and a second diode D2. A negative electrode of the second diode D2 is connected to the non-inverting input terminal of the operational amplifier. A positive electrode of the second diode D2 is connected to the second voltage reference plane. The second diode D2 is configured to prevent a surge from causing damage to the signal processing module 20 and back-end components. A negative electrode of the first diode D1 is connected to a first power supply. A positive electrode of the first diode D1 is connected to the non-inverting input terminal of the operational amplifier.

The signal processing module 20 further includes a filter circuit configured to perform filtering. The filter circuit is connected between the output terminal of the operational amplifier and the signal output terminal. The filter circuit includes a fifth resistor R5 and a first capacitor C1. The output terminal of the operational amplifier, the fifth resistor R5, the first capacitor C1, and the second voltage reference plane are sequentially connected. The signal output terminal is connected at a connection between the fifth resistor R5 and the first capacitor C1, to output the second voltage value V2. The filter processing of the amplification voltage V0 can be implemented by the foregoing RC filter loop, so as to obtain the second detection signal, that is, the second voltage value V2.

The alarm module determines the value of the impedance Rx according to the range of the second voltage value V2 to obtain the grounding status of the casing. When the second voltage value V2 exceeds a preset safe voltage range, the alarm module 30 sends an alarm, for example, a voice alarm, an acousto-optic alarm, or the like.

In a case where the casing of the foregoing connection detection circuit is grounded normally, the first voltage value V1 outputted by the detection output terminal is processed by the signal processing module 20, and then the second voltage value V2 is outputted to the alarm module 30. In this case, the second voltage value V2 is within the preset safe voltage range of the alarm module 30. The value of the impedance Rx of current grounding can be obtained in real time at the alarm module 30. When the casing is grounded abnormally, for example, the impedance Rx and the first connection port are disconnected, in this case, the detection output terminal is connected to the GND by the second resistor R2, and a low-level signal is obtained on the detection output terminal. As can be learned according to the foregoing calculation process, the alarm module 30 also obtains a low-level second voltage value V2. The alarm module 30 can determine, according to the second voltage value V2, that a current grounding line is disconnected, and send an alarm. For another example, in a case where the casing is poorly grounded, the impedance Rx is equivalent to a resistor with an extremely large resistance value. In this case, the detection output terminal similarly obtains a low-level signal. That is, the second voltage value V2 is also a low-level signal. The alarm module 30 calculates, according to the second voltage value V2, that the current resistance value of the impedance Rx exceeds a safety range, and also sends an alarm.

Example two

As shown in FIG. 3, a difference between the connection detection circuit in Example two and the connection detection circuit in Example one lies in that the first detection member is the second capacitor C2, and the remaining circuit components are the same. Therefore, the first voltage value V1 outputted by the detection output terminal satisfies the following formula:

$$V1 = \frac{Vpe \times R2}{\frac{1}{wC2}+R2+Rx},$$

where w = 2πf, and f is an operating frequency of an input voltage.

Because the circuit structure of the signal processing module 20 and the alarm module 30 is the same as that in Example one, the calculation of the amplification voltage V0 also satisfies the following formula:

$$V0 = \frac{V1 \times (R3+R4)}{R3}.$$

The filter circuit filters the amplification voltage V0 to obtain the second detection signal, that is, the second voltage value V2. The alarm module determines the value of the impedance Rx according to the range of the second voltage value V2 to obtain the grounding status of the casing.

The effect of Example two is the same as that of Example one. To avoid repetition, reference can be made to the description in Example one.

Another embodiment of the present invention provides an alarm apparatus, which includes the foregoing connection detection circuit. The alarm apparatus can be directly installed as an independent apparatus on various different powered equipment. A first connection port is led out from the alarm apparatus and is configured to be connected to a first voltage reference plane on powered equipment. The connection status of the powered equipment is detected by means of a voltage difference between the first voltage reference plane and a second voltage reference plane. The detection output terminal can output a first detection signal correlated with a potential difference between the first voltage reference plane and the second voltage reference plane. The signal processing module can generate a second detection signal that changes with the first detection signal. Therefore, the alarm module can accurately determine a connected state between the second voltage reference plane and the first voltage reference plane according to the second detection signal, so that the detection accuracy and reliability of connection detection can be improved.

Another embodiment of the present invention provides a base station, which includes the foregoing alarm apparatus. The grounding status of a base station system can be detected in real time by the foregoing alarm apparatus in the base station, thereby ensuring the electrical safety of the base station. In the alarm apparatus, the connection status of powered equipment is detected by means of a voltage difference between a first voltage reference plane and a second voltage reference plane. The detection output terminal can output a first detection signal correlated with a potential difference between the first voltage reference plane and the second voltage reference plane. The signal processing module can generate a second detection signal that changes with the first detection signal. Therefore, the alarm module can accurately determine a connected state between the second voltage reference plane and the first voltage reference plane according to the second detection signal, so that the detection accuracy and reliability of connection detection can be improved. The apparatus embodiments described above are only schematic. The units described as separate parts may or may not be physically separate. Some or all of the modules may be selected according to actual needs to achieve the objectives of the schemes in the embodiments.

The embodiments of the present invention include a first connection port, a detection module, a signal processing module, and an alarm module. The first connection port is configured to be connected to a first voltage reference plane. The detection module includes a first detection member, a second detection member, and a detection output terminal. The first detection member is serially connected between the first connection port and the detection output terminal. The second detection member is serially connected between the detection output terminal and a second voltage reference plane. The signal processing module includes a signal input terminal and a signal output terminal. The signal input terminal is connected to the detection output terminal. The signal processing module is configured to generate, according to a first detection signal outputted by the detection module through the detection output terminal, a second detection signal that changes with the first detection signal. The alarm module is connected to the signal output terminal, and is configured to determine a connected state between the second voltage reference plane and the first voltage reference plane according to the second detection signal outputted by the signal output terminal. According to the schemes provided in the embodiments of the present invention, in a case where the first connection port is connected to the first voltage reference plane, the detection output terminal can output a first detection signal correlated with a potential difference between the first voltage reference plane and the second voltage reference plane. The signal processing module can generate, according to the first detection signal, a second detection signal that changes with the first detection signal. Therefore, the alarm module can accurately determine a connected state between the second voltage reference plane and the first voltage reference plane according to the second detection signal, so that the detection accuracy and detection reliability of connection detection can be improved.

The above is a specific description of some implementations of the present invention, but the present invention is not limited to the above implementations. Those having ordinary skill in the art may make various modifications according to scope defined by the appended claims of the present invention.

**Claims**

1. A connection detection circuit, comprising:

   a first connection port, configured to be connected to a first voltage reference plane, wherein the first voltage reference plane is protective earthing;
   a detection module (10), comprising a first detection member, a second detection member, and a detection output terminal, wherein the first detection member is serially connected between the first connection port and the detection output terminal, and the second detection member is serially connected between the detection output terminal and a second voltage reference plane, the second voltage reference plane is functional earthing, and the detection output terminal is configured to output a first detection signal correlated with a potential difference between the first voltage reference plane and the second voltage reference plane;
   a signal processing module (20), comprising a signal input terminal and a signal output terminal, wherein the signal input terminal is connected to the detection output terminal, and the signal processing module (20) is configured to generate, according to the first detection signal, a second detection signal that changes with the first detection signal; and
   an alarm module (30), connected to the signal output terminal, and configured to determine a connected state between the first connection port and the first voltage reference plane according to the second detection signal outputted by the signal output terminal.

2. The connection detection circuit of claim 1, wherein the first detection member is a capacitor or a resistor, and the second detection member is a capacitor or a resistor.

3.  The connection detection circuit of claim 1, wherein the signal processing module (20) comprises an operational amplifier, a third resistor, and a fourth resistor, the operational amplifier comprises a non-inverting input terminal, an inverting input terminal, and an output terminal, the non-inverting input terminal of the operational amplifier is the signal input terminal, the inverting input terminal of the operational amplifier, the third resistor, and the second voltage reference plane are sequentially connected, and the output terminal of the operational amplifier is connected to the inverting input terminal of the operational amplifier via the fourth resistor.

4.  The connection detection circuit of claim 3, wherein the signal processing module (20) further comprises a clamp circuit, the clamp circuit comprises a second diode, a negative electrode of the second diode is connected to the non-inverting input terminal of the operational amplifier, and a positive electrode of the second diode is connected to the second voltage reference plane.

5.  The connection detection circuit of claim 4, wherein the clamp circuit comprises a first diode, a negative electrode of the first diode is connected to a first power supply, and a positive electrode of the first diode is connected to the non-inverting input terminal of the operational amplifier.

6.  The connection detection circuit of any one of claims 3 to 5, wherein the signal processing module (20) further comprises a filter circuit configured to perform filtering, and the filter circuit is connected between the output terminal of the operational amplifier and the signal output terminal.

7.  The connection detection circuit of claim 6, wherein the filter circuit comprises a fifth resistor and a first capacitor, the output terminal of the operational amplifier, the fifth resistor, the first capacitor, and the second voltage reference plane are sequentially connected, and the signal output terminal is connected to a connection point between the fifth resistor and the first capacitor.

8.  The connection detection circuit of claim 1, wherein the alarm module (30) is configured to:

    in response to the second detection signal being less than a first preset value, determine a nonconnected state between the first connection port and the first voltage reference plane; or, obtain an impedance between the first connection port and the first voltage reference plane according to the second detection signal; and determine, in response to the impedance being greater than a second preset value, a nonconnected state between the first connection port and the first voltage reference plane.

9.  An alarm apparatus, comprising the connection detection circuit of any one of claims 1 to 8.

10. A base station, comprising the alarm apparatus of claim 9.

**Patentansprüche**

1.  Verbindungserfassungsschaltung, umfassend:

    einen ersten Verbindungsanschluss, der konfiguriert ist, um mit einer ersten Spannungsreferenzebene verbunden zu sein, wobei die erste Spannungsreferenzebene eine Schutzerdung ist;
    ein Erfassungsmodul (10), umfassend ein erstes Erfassungselement, ein zweites Erfassungselement und einen Erfassungsausgangsanschluss, wobei das erste Erfassungselement in Reihe zwischen dem ersten Verbindungsanschluss und dem Erfassungsausgangsanschluss verbunden ist und das zweite Erfassungselement in Reihe zwischen dem Erfassungsausgangsanschluss und einer zweiten Spannungsreferenzebene verbunden ist, die zweite Spannungsreferenzebene eine Funktionserdung ist und der Erfassungsausgangsanschluss konfiguriert ist, um ein erstes Erfassungssignal auszugeben, das mit einer Potentialdifferenz zwischen der ersten Spannungsreferenzebene und der zweiten Spannungsreferenzebene korreliert ist;
    ein Signalverarbeitungsmodul (20), umfassend einen Signaleingangsanschluss und einen Signalausgangsanschluss, wobei der Signaleingangsanschluss mit dem Erfassungsausgangsanschluss verbunden ist und das Signalverarbeitungsmodul (20) konfiguriert ist, um gemäß dem ersten Erfassungssignal ein zweites Erfassungssignal zu erzeugen, das sich mit dem ersten Erfassungssignal ändert; und
    ein Alarmmodul (30), das mit dem Signalausgangsanschluss verbunden und konfiguriert ist, um einen Verbindungszustand zwischen dem ersten Verbindungsanschluss und der ersten Spannungsreferenzebene gemäß dem von dem Signalausgangsanschluss ausgegebenen zweiten Erfassungssignal zu bestimmen.

2.  Verbindungserfassungsschaltung nach Anspruch 1, wobei das erste Erfassungselement ein Kondensator oder ein Widerstand ist und das zweite Erfassungselement ein Kondensator oder ein Widerstand ist.

3. Verbindungserfassungsschaltung nach Anspruch 1, wobei das Signalverarbeitungsmodul (20) einen Betriebsverstärker, einen dritten Widerstand und einen vierten Widerstand umfasst, der Betriebsverstärker einen nichtinvertierenden Eingangsanschluss, einen invertierenden Eingangsanschluss und einen Ausgangsanschluss umfasst, der nichtinvertierende Eingangsanschluss des Betriebsverstärkers der Signaleingangsanschluss ist, der invertierende Eingangsanschluss des Betriebsverstärkers, der dritte Widerstand und die zweite Spannungsreferenzebene in Reihe verbunden sind und der Ausgangsanschluss des Betriebsverstärkers über den vierten Widerstand mit dem invertierenden Eingangsanschluss des Betriebsverstärkers verbunden ist.

4. Verbindungserfassungsschaltung nach Anspruch 3, wobei das Signalverarbeitungsmodul (20) ferner eine Klemmschaltung umfasst, die Klemmschaltung eine zweite Diode umfasst, eine negative Elektrode der zweiten Diode mit dem nichtinvertierenden Eingangsanschluss des Betriebsverstärkers verbunden ist und eine positive Elektrode der zweiten Diode mit der zweiten Spannungsreferenzebene verbunden ist.

5. Verbindungserfassungsschaltung nach Anspruch 4, wobei die Klemmschaltung eine erste Diode umfasst, wobei eine negative Elektrode der ersten Diode mit einer ersten Stromversorgung verbunden ist und eine positive Elektrode der ersten Diode mit dem nichtinvertierenden Eingangsanschluss des Betriebsverstärkers verbunden ist.

6. Verbindungserfassungsschaltung nach einem der Ansprüche 3 bis 5, wobei das Signalverarbeitungsmodul (20) ferner eine Filterschaltung umfasst, die zum Durchführen einer Filterung konfiguriert ist, und die Filterschaltung zwischen dem Ausgangsanschluss des Betriebsverstärkers und dem Signalausgangsanschluss verbunden ist.

7. Verbindungserfassungsschaltung nach Anspruch 6, wobei die Filterschaltung einen fünften Widerstand und einen ersten Kondensator umfasst, der Ausgangsanschluss des Betriebsverstärkers, der fünfte Widerstand, der erste Kondensator und die zweite Spannungsreferenzebene nacheinander miteinander verbunden sind und der Signalausgangsanschluss mit einem Verbindungspunkt zwischen dem fünften Widerstand und dem ersten Kondensator verbunden ist.

8. Verbindungserfassungsschaltung nach Anspruch 1, wobei das Alarmmodul (30) zu Folgendem konfiguriert ist:

als Reaktion darauf, dass das zweite Erfassungssignal kleiner ist als ein erster voreingestellter Wert, Bestimmen eines nicht verbundenen Zustands zwischen dem ersten Verbindungsanschluss und der ersten Spannungsreferenzebene; oder
Erlangen einer Impedanz zwischen dem ersten Verbindungsanschluss und der ersten Spannungsreferenzebene gemäß dem zweiten Erfassungssignal; und Bestimmen, als Reaktion darauf, dass die Impedanz größer ist als ein zweiter voreingestellter Wert, eines nicht verbundenen Zustands zwischen dem ersten Verbindungsanschluss und der ersten Spannungsreferenzebene.

9. Alarmvorrichtung, umfassend die Verbindungserfassungsschaltung nach einem der Ansprüche 1 bis 8.

10. Basisstation, umfassend die Alarmvorrichtung nach Anspruch 9.

**Revendications**

1. Circuit de détection de connexion, comprenant :

un premier terminal de connexion, configuré pour être connecté à un premier plan de référence de tension, dans lequel ce premier plan de référence de tension étant une protection par mise à la terre ;
un module de détection (10), comprenant un premier élément de détection, un deuxième élément de détection, et une borne de sortie de détection, dans lequel le premier élément de détection est connecté en série entre le premier port de connexion et la borne de sortie de détection, et le deuxième élément de détection est connecté en série entre la borne de sortie de détection et un deuxième plan de référence de tension, le deuxième plan de référence de tension est une protection par mise à la terre, et la borne de sortie de détection est configurée pour émettre un premier signal de détection corrélé à une différence de potentiel entre le premier plan de référence de tension et le deuxième plan de référence de tension ;
un module de traitement de signal (20), comprenant une borne d'entrée de signal et une borne de sortie de signal, dans lequel la borne d'entrée de signal est connectée à la borne de sortie de détection, et le module de traitement de signal (20) est configuré pour générer, en fonction du premier signal de détection, un deuxième signal de détection qui varie en fonction du premier signal de détection ; et

un module d'alarme (30), connecté à la borne de sortie de signal, et configuré pour déterminer l'état de la connexion entre le premier port de connexion et le premier plan de référence de tension en fonction du deuxième signal de détection émis par la borne de sortie de signal.

2. Circuit de détection de connexion selon la revendication 1, dans lequel le premier élément de détection est un condensateur ou une résistance, et le deuxième élément de détection est un condensateur ou une résistance.

3. Circuit de détection de connexion selon la revendication 1, dans lequel le module de traitement de signal (20) comprend un amplificateur opérationnel, une troisième résistance et une quatrième résistance, l'amplificateur opérationnel comportant une borne d'entrée non inverseuse, une borne d'entrée inverseuse et une borne de sortie, la borne d'entrée non inverseuse de l'amplificateur opérationnel constituant la borne d'entrée de signal, la borne d'entrée inverseuse de l'amplificateur opérationnel, la troisième résistance et le deuxième plan de référence de tension sont connectés en série, et la borne de sortie de l'amplificateur opérationnel est connectée à la borne d'entrée inverseuse de l'amplificateur opérationnel via la quatrième résistance.

4. Circuit de détection de connexion selon la revendication 3, dans lequel le module de traitement de signal (20) comprend en outre un circuit de verrouillage, le circuit de verrouillage comprenant une deuxième diode, l'électrode négative de la deuxième diode étant connectée à la borne d'entrée non inverseuse de l'amplificateur opérationnel, et l'électrode positive de la deuxième diode étant connectée au deuxième plan de référence de tension.

5. Circuit de détection de connexion selon la revendication 4, dans lequel le circuit de verrouillage comprend une première diode, dont l'électrode négative est connectée à une première source d'alimentation et dont l'électrode positive est connectée à la borne d'entrée non inverseuse de l'amplificateur opérationnel.

6. Circuit de détection de connexion selon l'une quelconque des revendications 3 à 5, dans lequel le module de traitement de signal (20) comprend en outre un circuit de filtrage configuré pour effectuer un filtrage, et ledit circuit de filtrage est connecté entre la borne de sortie de l'amplificateur opérationnel et la borne de sortie de signal.

7. Circuit de détection de connexion selon la revendication 6, dans lequel le circuit de filtrage comprend une cinquième résistance et un premier condensateur, la borne de sortie de l'amplificateur opérationnel, la cinquième résistance, le premier condensateur et le deuxième plan de référence de tension sont connectés en série, et la borne de sortie de signal est connectée à un point de jonction entre la cinquième résistance et le premier condensateur.

8. Circuit de détection de connexion selon la revendication 1, dans lequel le module d'alarme (30) est configuré pour :

en réponse au fait que le deuxième signal de détection est inférieur à une première valeur prédéfinie, déterminer un état de non-connexion entre le premier port de connexion et le premier plan de référence de tension ; ou, obtenir une impédance entre le premier port de connexion et le premier plan de référence de tension en fonction du deuxième signal de détection ; et déterminer, lorsque cette impédance est supérieure à une deuxième valeur prédéfinie, un état de non-connexion entre le premier port de connexion et le premier plan de référence de tension.

9. Dispositif d'alarme, comprenant le circuit de détection de connexion selon l'une quelconque des revendications 1 à 8.

10. Station de base, comprenant le dispositif d'alarme selon la revendication 9.

Fig. 1

Fig. 2

Fig. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20180149688 A1
- CN 203561719 U
- WO 2017108134 A1